# EUROPEAN PATENT APPLICATION

(11) **EP 4 742 048 A1**
(43) Date of publication of application: **13.05.2026**
(21) Application number: 25211205.7
(22) Date of filing: 24.10.2025
(51) Int. Cl.: G06F 13/16, G06F 3/06

(54) **MEMORY PACKAGE INCLUDING PLURALITY OF STORAGE DEVICES**

(30) Priority: 08.11.2024 KR 20240158292
(71) Applicant: Samsung Electronics Co., Ltd., Suwon-si, Gyeonggi-do 16677 (KR)
(72) Inventor: YANG, Seungyoon, 16677 Suwon-si (KR); KIM, Eunah, 16677 Suwon-si (KR); YOO, Suhwa, 16677 Suwon-si (KR)
(74) Representative: Marks & Clerk LLP

(57) **Abstract**

A memory package includes a first storage device including a first controller configured to communicate with a host, and a second storage device including a second controller configured to communicate with the host, and perform a synchronization operation on the second storage device based on a synchronization signal received from the first controller. The first controller includes a first synchronizer configured to generate the synchronization signal based on a state of the first storage device, and a first pin electrically connected to the second controller. The second controller includes a second synchronizer configured to control the second controller to perform a synchronization operation based on the synchronization signal, and a second pin electrically connected to the first controller. The first synchronizer provides the synchronization signal to the second synchronizer via the first pin and the second pin.

## Description

### FIELD

The present disclosure relates to a memory package, and more particularly, to a memory package including a plurality of storage devices.

### BACKGROUND

A universal flash storage (UFS) is a storage interface for supporting high-speed data transmission, and is widely used in compact electronic devices such as mobile devices. According to the UFS 4.0 Standard of the Joint Electron Device Engineering Council (JEDEC), which defines standard specifications for UFS devices, the connection between a host and the UFS device may be implemented in a 2-LANE manner.

As artificial intelligence (AI) technology is rapidly developing, there is an increasing need to quickly process a large amount of data. In particular, as high transmission speed is required for learning AI models and real-time data processing, UFS systems communicating with hosts in a 2-LANE manner are experiencing limitations in meeting the data transmission requirement. Against the backdrop, a new technological approach is needed to further increase the data transmission speed between the host and the UFS storage.

### SUMMARY

One or more embodiments provide a memory package including a plurality of universal flash storage (UFS) devices for increasing data transmission speed between a host and a memory package.

Further, in one or more embodiments, operations of the plurality of UFS devices may be synchronized by transceiving synchronization signals between the plurality of UFS devices included in one memory package. By synchronizing the operations of the UFS devices, the temperature of the memory package may be efficiently managed.

Further, in one or more embodiments, by synchronizing the operations of the UFS devices, the speed between a host and the plurality of UFS devices may be stably maintained.

The issues addressed by embodiments are not limited to the above-mentioned issues, and other issues not mentioned may be clearly understood by one of ordinary skill in the art from the following descriptions.

According to an aspect of the disclosure, there is provided a memory package including a first storage device including a first controller configured to communicate with a host, and a second storage device including a second controller configured to communicate with the host, and perform a synchronization operation on the second storage device based on a synchronization signal received from the first controller, wherein the first controller includes a first synchronizer configured to generate the synchronization signal based on a state of the first storage device, and a first pin electrically connected to the second controller, wherein the second controller includes a second synchronizer configured to control the second controller to perform a synchronization operation, based on the synchronization signal, and a second pin electrically connected to the first controller, and wherein the first synchronizer is configured to provide the synchronization signal to the second synchronizer via the first pin and the second pin.

According to an aspect of the disclosure, there is provided a memory package including a first storage device including a first controller configured to communicate with a host, and a second storage device including a second controller configured to communicate with the host, and perform a synchronization operation on the second storage device based on a trigger signal received from the first controller, wherein the first controller includes a first synchronizer configured to generate the trigger signal based on a state of the first storage device, and a first trigger pin and a first data pin electrically connected to the second controller, wherein the second controller includes a second synchronizer configured to control the second controller to perform a synchronization operation, based on the trigger signal and the data signal, and a second trigger pin and a second data pin electrically connected to the first controller, and wherein the first synchronizer is further configured to provide the trigger signal to the second synchronizer via the first trigger pin and the second trigger pin, and provide the data signal to the second synchronizer via the first data pin and the second data pin.

According to an aspect of the disclosure, there is provided a memory package including a first storage device including a first controller configured to communicate with a host, a second storage device including a second controller configured to communicate with the host, and perform a synchronization operation on the second storage device based on a synchronization signal received from the first controller, and a third storage device including a third controller configured to communicate with the host, and perform the synchronization operation on the third storage device based on the synchronization signal received from the first controller, wherein the first controller includes a first synchronizer configured to generate the synchronization signal based on a state of the first storage device, wherein the second controller includes a second synchronizer configured to control the second controller to perform the synchronization operation, based on the synchronization signal, and wherein the third controller includes a third synchronizer configured to control the third controller to perform the synchronization operation, based on the synchronization signal.

At least some of the above and other features of the invention are set out in the claims.

### BRIEF DESCRIPTION OF THE DRAWINGS

The above and other aspects, features, and advantages of certain embodiments of the present disclosure will be more apparent from the following description taken in conjunction with the accompanying drawings.
FIG. 1 is a block diagram of a system according to an embodiment.
FIG. 2 is a block diagram of a first controller according to an embodiment.
FIG. 3 is a diagram of an interface between a host and first and second storage devices of the system of FIG. 1.
FIG. 4 is a diagram of a synchronization operation between a first controller and a second controller.
FIG. 5 is a diagram of a synchronization operation between the first controller and the second controller.
FIG. 6 is a diagram of a synchronization operation between the first controller and the second controller.
FIG. 7 is a diagram for describing that a storage device according to an embodiment generates a synchronization signal based on a temperature of the storage device.
FIG. 8 is a flowchart of an operation of a storage device, according to an embodiment.
FIG. 9 is a flowchart of an operation of the storage device, according to an embodiment.
FIG. 10 is a block diagram of a system according to an embodiment.
FIG. 11 is a block diagram of a system according to an embodiment.

### DETAILED DESCRIPTION

Hereinafter, example embodiments of the disclosure are described in detail with reference to the accompanying drawings. When descriptions are given with reference to drawings, identical or corresponding components may be given with identical drawing reference numbers, and duplicate descriptions thereof are omitted

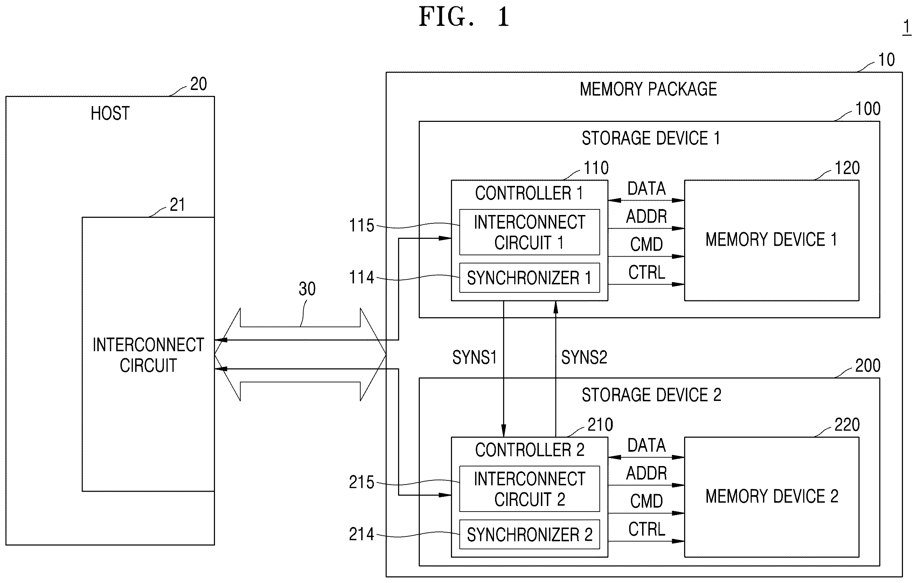

FIG. 1 is a block diagram of a system 1 according to an embodiment.

Referring to FIG. 1, the system 1 may include a memory package 10 and a host 20.

The memory package 10 may include a first storage device 100 and a second storage device 200. In the example of FIG. 1, the memory package 10 includes two storage devices. However, in other examples, the memory package 10 may include more than two storage devices. In some embodiments, the memory package 10 may be referred to as a storage system.

In an embodiment, the first and second storage devices 100 and 200 may be implemented with different semiconductor chips, and mounted in one memory package 10.

The system 1 may use various interfaces for communication between the host 20 and the memory package 10, and as an example, the system 1 may use various interfaces, such as a universal serial bus (USB) interface, a multi-media card (MMC) interface, an embedded MMC (eMMC) interface, a peripheral component interconnect (PCI) interface, a PCI-E interface, an advanced technology attachment (ATA) interface, a serial-ATA interface, a parallel-ATA interface, a small computer system interface (SCSI), an enhanced small disk interface (ESDI), an integrated drive electronics (IDE) interface, a Firewire interface, a non-volatile memory (NVM) express (NVMe) interface, and a universal flash storage (UFS) interface.

According to some embodiments, the memory package 10 may be implemented as a memory embedded in an electronic device or as a removable memory, and the memory package 10 may be implemented in various forms of, for example, an embedded UFS memory device, an embedded multi-media card (eMMC), a solid state drive (SSD), a UFS memory card, a compact flash (CF) card, a secure digital (SD) card, a micro-SD card, a mini-SD card, an extreme digital (xD) card, and a memory stick.

In embodiments below, as the UFS interface is employed in the system 1, it is assumed that the host 20 and the first and second storage devices 100 and 200 generate packets according to the protocol of the UFS interface, and communicate with each other.

The first storage device 100 may include a first controller 110 and a first memory device 120.

The first controller 110 may control the first memory device 120 to read data stored in the first memory device 120 or to write data to the first memory device 120, in response to a read/write request from the host 20. The first controller 110 may control write, read, and erase operations of the first memory device 120, by providing an address ADDR, a command CMD, and a control signal CTRL to the first memory device 120. In addition, the data DATA for programming and the read data DATA may be communicated between the first controller 110 and the first memory device 120.

The first memory device 120 may include a three-dimensional (3D) memory cell array, the 3D memory cell array may include a plurality of NAND strings, and each NAND string may include the memory cells respectively connected to the word lines WL vertically stacked on a substrate. However, embodiments are not limited thereto, and in some embodiments, the memory cell array may include a two-dimensional (2D) memory cell array, and the 2D memory cell array may include the plurality of NAND strings arranged in row and column directions. However, embodiments are not limited thereto, and the memory cell array may include various types of NVM cells, such as resistive random access memory (RAM) (ReRAM), phase change RAM (PRAM), and magnetic RAM (MRAM).

The first controller 110 and the second controller 210 may communicate with each other between the first and second storage devices 100, 200 without using the host 20. Operations of each of the first and second storage devices 100, 200 may be synchronized by using a synchronization signal between the first controller 110 and the second controller 210.

Synchronizing the operations of the first and second storage devices 100, 200 may mean that each of the first and second devices 100, 200 performs the same operation. For example, when the first storage device 100 operates in a throttling mode, and when the second storage device 200 also operates in the throttling mode, the second storage device 200 may perform the synchronization operation, and thus the first and second storage devices 100, 200 may be synchronized.

Operation in a throttling mode includes the storage device reducing its operation speed by itself to prevent an occurrence of damages due to heat generated when the temperature of the storage device exceeds a particular temperature as the storage device is heated.

The first controller 110 may include a first synchronizer 114 and a first interconnect circuit 115. The first synchronizer 114 may monitor the state of the first storage device 100, generate a first synchronization signal SYNS1 based on the monitoring result, and provide the first synchronization signal SYNS1 to a second synchronizer 214 of the second controller 210.

In an embodiment, a synchronization signal may include a signal directing another storage device to perform a synchronization operation. A synchronization operation may mean, for example, an operation of changing an operation mode of a storage device to a throttling mode or a background operation. In this case, the background operation may include, for example, a garbage collection operation.

In an embodiment, when the temperature of the first storage device 100 is greater than or equal to a reference value, the first controller 110 may determine that the first storage device 100 operates in the throttling mode. In some embodiments, the throttling mode may be referred to as a dynamic thermal throttling (DTT) mode. The first controller 110 may generate the first synchronization signal SYNS1 by using the first synchronizer 114, and may provide the first synchronization signal SYNS1 to the second synchronizer 214 of the second controller 210. The first controller 110 may operate in the throttling mode after providing the first synchronization signal SYNS1 to the second controller 210. The second synchronizer 214 may control the second controller 210 to operate in the throttling mode in response to the first synchronization signal SYNS1.

The temperature of the first storage device 100 may increase in various situations. For example, there may be a case in which a large amount of data is transmitted between the first storage device 100 and the host 20. When the temperature of the first storage device 100 exceeds the reference value, by changing the operation mode of the first storage device 100 to the throttling mode, heat management may be performed by temporarily lowering the performance of the first storage device 100. In this case, when the first storage device 100 alone enters the throttling mode, only the operating speed of the first storage device 100 may be lowered. In this case, it may be determined that a defect has occurred in the first storage device 100 from the standpoint of the host 20, but this determination may not be an appropriate determination. Accordingly, the memory package 10 according to an embodiment may, when the first storage device 100 needs to operate in the throttling mode, not only efficiently manage the heat of the memory package 10 by also operating the second storage device 200 in the throttling mode, but also prevent the host 20 from determining in error that the first and second storage devices 100 and 200 included in the memory package 10 have failed or are defective.

In an embodiment, when the first storage device 100 has to perform the garbage collection operation, the first controller 110 may determine that the first storage device 100 performs the garbage collection operation. The first controller 110 may generate the first synchronization signal SYNS1 by using the first synchronizer 114, and may provide the first synchronization signal SYNS1 to the second synchronizer 214 of the second controller 210. The first controller 110 may perform the garbage collection operation after providing the first synchronization signal SYNS1 to the second controller 210. The second synchronizer 214 may control the second controller 210 to perform the garbage collection operation in response to the first synchronization signal SYNS1.

When the first controller 110 performs the garbage collection operation on the first storage device 100, the second controller 210 may also quickly complete the garbage collection operation on the first and second storage devices 100, 200 in the memory package 10 by performing the garbage collection operation on the second storage device 200.

The host 20 may include an interconnect circuit 21. The interconnect circuit 21 may provide an interface 30 between the host 20 and the first storage device 100 and the second storage device 200. The host 20 may communicate data to and from the first and second storage devices 100 and 200 of the memory package 10 via the interconnect circuit 21. The interconnect circuit 21 may include physical components for exchanging data with the host 20, and may include at least one receiver, at least one transmitter, etc.

The second storage device 200 may include the second controller 210 and a second memory device 220. The second controller 210 may include the second synchronizer 214 and a second interconnect circuit 215. The second synchronizer 214 may monitor the state of the second storage device 200, generate a second synchronization signal SYNS2 based on the monitoring result, and provide the second synchronization signal SYNS2 to the first synchronizer 114 of the first controller 110. The second storage device 200 may have components similar to those of the first storage device 100, and duplicate descriptions thereof are omitted.

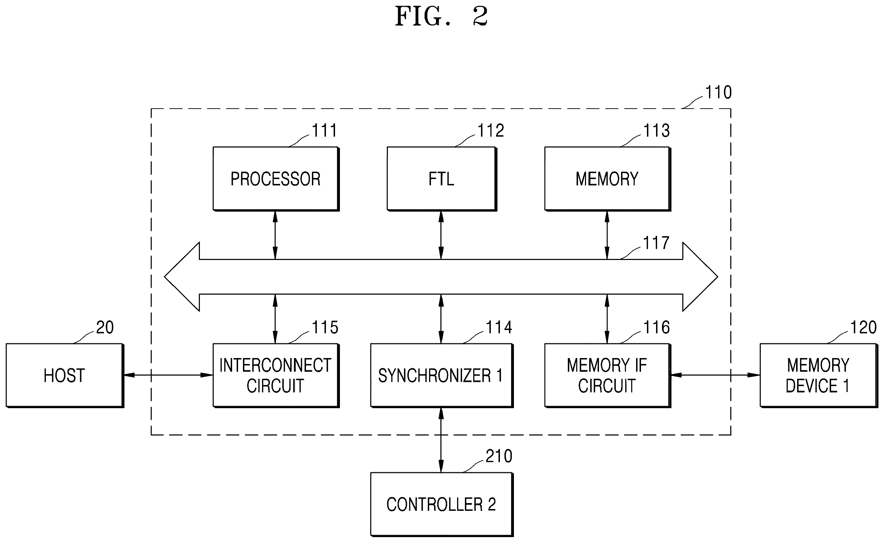

FIG. 2 is a block diagram of the first controller 110 according to an embodiment. FIG. 2 may be described with reference to FIG. 1, and duplicate descriptions thereof are omitted.

Referring to FIG. 2, the first controller 110 may include a processor 111, a flash translation layer (FTL) 112, a memory 113, the first synchronizer 114, the first interconnect circuit 115, and a memory interface circuit 116, which may communicate with each other via a bus 117.

The processor 111 may include a central processing unit, a microprocessor, or the like, and may control the overall operation of the first controller 110. The processor 111 may include one or more processor cores capable of executing an instruction set of program code configured to perform a particular operation. For example, the processor 111 may execute command code of firmware stored in the memory 113.

The FTL 112 may perform various functions, such as an address mapping operation, a wear-leveling operation, and the garbage collection operation. The address mapping operation may be an operation of converting a logical address received from a host into a physical address used to actually store data in the first memory device 120. The wear-leveling operation may be technology for preventing excessive deterioration of a particular block by uniformly using blocks in the first memory device 120, and may be implemented by using firmware technology that balances erase counts of physical blocks. The garbage collection operation may be technology for securing usable capacity in the first memory device 120 by copying the effective data of a block to a new block and then erasing the block.

The memory 113 may be used as a working memory, a buffer memory, a cache memory, or the like, and the memory 113 may be implemented as, for example, dynamic RAM (DRAM), static RAM (SRAM), PRAM, or flash memory.

The first synchronizer 114 may monitor the state of the first storage device 100, and provide the synchronization signal to the second controller 210 based on the monitoring result. The first synchronizer 114 may control the first controller 110 to perform the synchronization operation, based on the synchronization signal provided by the second synchronizer 214.

In an embodiment, when the temperature of the first storage device 100 is greater than or equal to a reference value, the first controller 110 may control the first storage device 100 to operate in the throttling mode. When the first controller 110 determines to change the operation mode of the first storage device 100 to the throttling mode, the first synchronizer 114 may control the second storage device 200 to also operate in the throttling mode by providing the synchronization signal to the second controller 210.

In an embodiment, when the first controller 110 determines to perform the garbage collection operation, the first synchronizer 114 may control the second storage device 200 to also perform the garbage collection operation by providing the synchronization signal to the second controller 210.

The first interconnect circuit 115 may provide an interface, between the host 20 and the first controller 110, for example, USBMMC, PCI-E, ATA, serial ATA (SATA), parallel ATA (PATA), SCSI, serial attached SCSI (SAS), ESDI, IDE, etc. The first interconnect circuit 115 may receive requests and data from the host 20, and output data to the host 20.

The memory interface circuit 116 may provide an interface between the first controller 110 and the first memory device 120. For example, the data (DATA in FIG. 1), the command (CMD in FIG. 1), the address (ADDR in FIG. 1), and the control signal (CTRL in FIG. 1) may be communicated between the first controller 110 and the first memory device 120 via the memory interface circuit 116.

The bus 117 may operate based on one of various bus protocols. The various bus protocol may include at least one of advanced microcontroller bus architecture (AMBA) protocol, USB protocol, MMC protocol, PCI protocol, PCI-E protocol, ATA protocol, SATA protocol, PATA protocol, SCSI protocol, ESDI protocol, IDE protocol, MIPI protocol, UFS protocol, etc.

The second controller 210 may have the same structure as the first controller 110, and duplicate descriptions thereof are omitted.

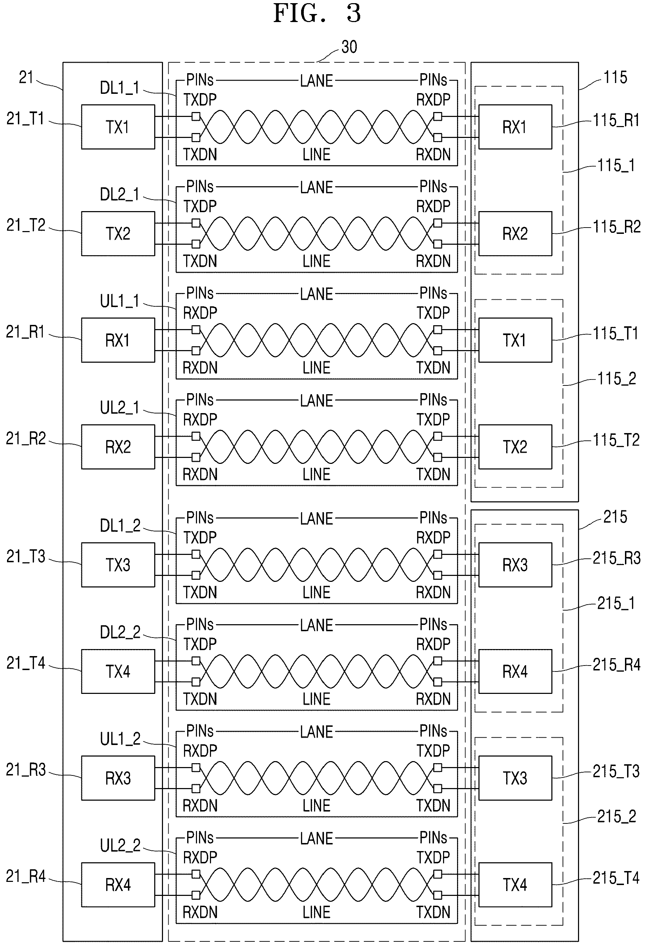

FIG. 3 is a diagram of the interface 30 between the host 20 and the first storage device 100 in FIG. 1. FIG. 3 may be described with reference to FIGS. 1 and 2, and duplicate descriptions thereof may be omitted.

Referring to FIG. 3, the interconnect circuit 21 of the host (20 in FIG. 1) may include first through fourth transmitters 21_T1 through 21_T4 and first through fourth receivers 21_R1 through 21_R4.

The first interconnect circuit 115 of the first storage device 100 may include a first receiving circuit 115_1 and a first transmitting circuit 115_2. The first receiving circuit 115_1 may include first and second receivers 115_R1 and 115_R2. The first transmitting circuit 115_2 may include first and second transmitters 115_T1 and 115_T2.

The second interconnect circuit 215 of the second storage device 200 may include a second receiving circuit 215_1 and a second transmitting circuit 215_2. The second receiving circuit 215_1 may include third and fourth receivers 215_R3 and 215_R4. The second transmitting circuit 215_2 may include third and fourth transmitters 215_T3 and 215_T4.

Hereinafter, for convenience of description, among a plurality of transmitters and receivers included in the interconnect circuit 21 and the first interconnect circuit 115, the first transmitter 21_T1 of the interconnect circuit 21 of the host 20 and the first receiver 115_R1 of the first interconnect circuit 115 of the first storage device 100 are representatively described.

Referring to FIG. 3, the interface 30 may support a plurality of lanes LANE. Each lane LANE may include a transmission channel for transmitting data including unidirectional single-signals. The lane LANE may include the first transmitter 21_T1, the first receiver 115_R1, and a line LINE for point-to-point interconnection between the first transmitter 21_T1 and the first receiver 115_R1. The first transmitter 21_T1 or the first receiver 115_R1 may have one differential output or input line interface that matches two signaling pins PIN. The signaling pins PIN may be individually represented as DP indicating a positive node of a differential signal and DN indicating a negative node of a differential signal. An optional prefix TX or RX for indicating the first transmitter 21_T1 pin or the first receiver 115_R1 pin may be applied to each of the DP and DN of the signaling pins PIN. The line LINE may include two differentially routed wires connecting the signaling pins PIN of the first transmitter 21_T1 and the first receiver 115_R1. These wires may be transmission lines.

The interface 30 may include at least one lane LANE in each direction. A lane formed in a direction from the host 20 to the first storage device 100 or the second storage device 200 may be referred to as a downstream lane. A lane formed from the first storage device 100 or the second storage device 200 to the host 20 may be referred to as an upstream lane.

In the embodiment, the number of lanes formed between the host 20 and the first storage device 100 may be the same as the number of lanes formed between the host 20 and the second storage device 200. For example, a connection formed between the host 20 and the first interconnect circuit 115 of the first storage device 100 may include two lanes, and a connection formed between the host 20 and the second interconnect circuit 215 of the second storage device 200 may also include two lanes LANE.

Two downstream lanes between the host 20 and the first storage device 100, that is, a first downstream lane DL1_1 and a second downstream lane DL2_1 may be formed. Between the host 20 and the first storage device 100, two upstream lanes, that is, a first upstream lane UL1_1 and a second upstream lane UL2_1 may be formed. Such a connection between the host 20 and the first storage device 100 may be referred to as a 2-lane structure.

Similarly, between the host 20 and the second storage device 200, two downstream lanes, that is, a first downstream lane DL1_2 and a second downstream lane DL2_2, may be formed. Between the host 20 and the second storage device 200, two upstream lanes, that is, a first upstream lane UL1_2 and a second upstream lane UL2_2, may be formed.

Because the host 20 and the first storage device 100 has the 2-lane structure, and the host 20 and the second storage device 200 also has the 2-lane structure, the host 20 and the memory package 10 may have a 4-lane structure.

In an embodiment, when the connection between the host 20 and the first storage device 100 or the second storage device 200 is configured as the 2-lane structure, it is assumed that a sequential read speed is about 4 GB/s. In this case, because the connection between the host 20 and the memory package 10 is configured as the 4-lane structure, the sequential read speed may be about 8 GB/s.

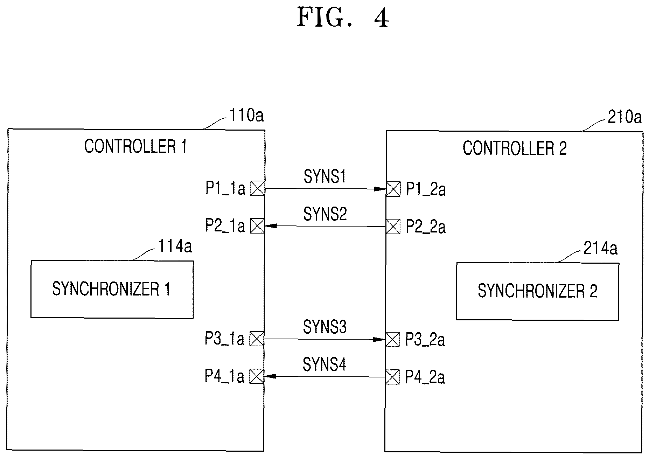

FIG. 4 is a diagram of showing the connections between a first controller 110a and a second controller 210a for performing a synchronization operation between the first controller 110a and the second controller 210a. FIG. 4 may be described with reference to FIGS. 1 through 3, and duplicate descriptions thereof may be omitted.

Referring to FIG. 4, the first controller 110a may correspond to an example of the first controller 110 in FIG. 1. The first controller 110a may include a first synchronizer 114a and first through fourth pins P1_1a through P4_1a. The second controller 210a may correspond to an example of the second controller 210 in FIG. 1. The second controller 210a may include a second synchronizer 214a and first through fourth pins P1_2a through P4_2a. The first through fourth pins P1_1a through P4_1a of the first controller 110a may be electrically connected to the first through fourth pins P1_2a through P4_2a of the second controller 210a, respectively.

The first synchronizer 114a may generate the first synchronization signal SYNS1 and a third synchronization signal SYNS3. The second synchronizer 214a may generate the second synchronization signal SYNS2 and a fourth synchronization signal SYNS4.

In the embodiment, the synchronization operations directed by the first synchronization signal SYNS1 and the third synchronization signal SYNS3 may be different from each other. The synchronization operations directed by the second synchronization signal SYNS2 and the fourth synchronization signal SYN4 may be different from each other.

The first synchronizer 114a may provide the first synchronization signal SYNS1 to the second synchronizer 214a of the second controller 210a via the first pin P1_1a. The second controller 210a may perform the synchronization operation directed by the first synchronization signal SYNS1, in response to the first synchronization signal SYNS1 received from the first synchronizer 114a via the first pin P1_2a.

In the embodiment, the synchronization operation directed by the first synchronization signal SYNS1 to the second controller 210a may include changing the operation mode of the second storage device 200 to the throttling mode.

The second synchronizer 214a may provide the second synchronization signal SYNS2 to the first synchronizer 114a of the first controller 110a via the second pin P2_2a. The first controller 110a may perform the synchronization operation directed by the second synchronization signal SYNS2, in response to the second synchronization signal SYNS2 received from the second synchronizer 214a, via the second pin P2_1a.

In the embodiment, the synchronization operation directed by the second synchronization signal SYNS2 to the first controller 110a may include changing the operation mode of the first storage device 100 to the throttling mode.

The first synchronizer 114a may provide the third synchronization signal SYNS3 to the second synchronizer 214a of the second controller 210a via the third pin P3_1a. The second controller 210a may perform the synchronization operation directed by the third synchronization signal SYNS3, in response to the third synchronization signal SYNS3 received from the first synchronizer 114a, via the third pin P3_2a.

In the embodiment, the synchronization operation directed by the third synchronization signal SYNS3 to the second controller 210a may include the garbage collection operation.

The second synchronizer 214a may provide the fourth synchronization signal SYNS4 to the first synchronizer 114a of the first controller 110a via the fourth pin P4_2a. The first controller 110a may perform the synchronization operation directed by the fourth synchronization signal SYNS4, in response to the fourth synchronization signal SYNS4 received from the second synchronizer 214a, via the fourth pin P4_1a.

In the embodiment, the synchronization operation directed by the fourth synchronization signal SYNS4 to the first controller 110a may include the garbage collection operation.

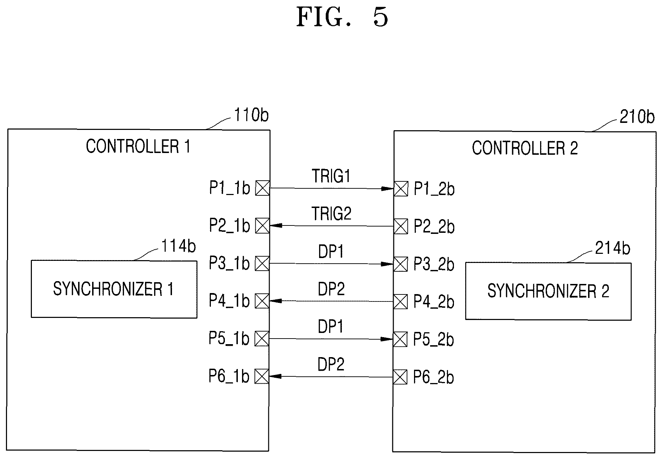

FIG. 5 is a diagram of the synchronization operation between a first controller 110b and a second controller 210b. FIG. 5 is a diagram of a case in which a multi-connection is formed between the first controller 110b and the second controller 210b, and a parallel data signal is transmitted. FIG. 5 may be described with reference to FIGS. 1 through 4, and duplicate descriptions thereof may be omitted.

Referring to FIG. 5, the first controller 110b may correspond to an example of the first controller 110 in FIG. 1. The first controller 110b may include a first synchronizer 114b and first through sixth pins P1_1b through P6_1b. The second controller 210b may correspond to an example of the second controller 210 in FIG. 1. The second controller 210b may include a second synchronizer 214b and first through sixth pins P1_2b through P6_2b. In FIG. 5, each of a first data signal DP1 and a second data signal DP2 is illustrated as a 2-bit signal transmitted via two pins, but this is an example, and in general, the first data signal DP1 and the second data signal DP2 may include an n-bit signal transmitted via n pins (where n is a natural number greater than 2). The first through sixth pins P1_1b through P6_1b of the first controller 110b may be electrically connected to the first through sixth pins P1_2b through P6_2b of the second controller 210b, respectively.

The synchronization signal provided by the first controller 110b to the second controller 210b may include a first trigger signal TRIG1 and the first data signal DP1. The first data signal DP1 may include signals transmitted in parallel via a plurality of pins.

The first synchronizer 114b may provide the first trigger signal TRIG1 to the second synchronizer 214b of the second controller 210b via the first pin P1_1b of the first controller 110b. The second controller 210b may receive the first trigger signal TRIG1 from the first synchronizer 114b via the first pin P1_2b of the second controller 210b. The first synchronizer 114b may provide the first data signal DP1 to the second controller 210b via the third pin P3_1b and the fifth pin P5_1b of the first controller 110b. The second controller 210b may receive the first data signal DP1 from the first synchronizer 114b via the third pin P3_2b and the fifth pin P5_2b of the second controller 210b. When the first trigger signal TRIG1 and the first data signal DP1 are received from the first synchronizer 114b, the second controller 210b may perform the synchronization operation based on the value directed by the first data signal DP1.

In the embodiment, when the value represented by the first data signal DP1 is a first value (for example, 2'b00), the first data signal DP1 may include a signal that instructs the second controller 210b to change the operation mode of the second storage device 200 to the throttling mode.

In the embodiment, when the value represented by the first data signal DP1 is a second value (for example, 2'b01), the first data signal DP1 may include a signal that instructs the second controller 210b to stop the operation mode at the throttling mode and change the operation mode to the normal mode.

In the embodiment, when the value represented by the first data signal DP1 is a third value (for example, 2'b10), the first data signal DP1 may include a signal that instructs the second controller 210b to perform the garbage collection operation.

In the embodiment, when the value represented by the first data signal DP1 is a fourth value (for example, 2'b11), the first data signal DP1 may include a signal that instructs the second controller 210b to stop the garbage collection operation.

The synchronization signal provided by the second controller 210b to the first controller 110b may include a second trigger signal TRIG2 and the second data signal DP2. The second data signal DP2 may include signals transmitted in parallel through a plurality of pins.

The second synchronizer 214b may provide the second trigger signal TRIG2 to the first synchronizer 114b of the first controller 110b via the second pin P2_2b of the second controller 210b. The first controller 110b may receive the second trigger signal TRIG2 from the second synchronizer 214b via the second pin P2_1b of the first controller 110b.

The second synchronizer 214b may provide the second data signal DP2 to the first controller 110b via the fourth pin P4_2b and the sixth pin P6_2b of the second controller 210b. The first controller 110b may receive the second data signal DP2 from the second synchronizer 214b via the fourth pin P4_1b and the sixth pin P6_1b of the first controller 110b.

When the second trigger signal TRIG2 and the second data signal DP2 are received from the second synchronizer 214b, the first controller 110b may perform the synchronization operation based on the value represented by the second data signal DP2. In this case, the synchronization operation according to the value represented by the second data signal DP2 may be the same as that of the first data signal DP1, and duplicate descriptions thereof are omitted.

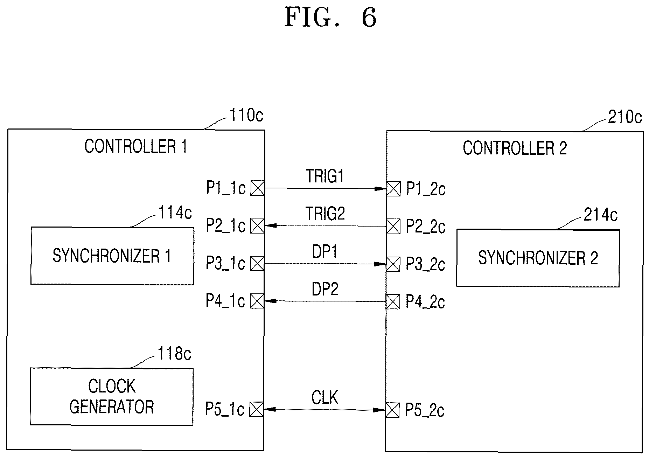

FIG. 6 is a diagram of the synchronization operation between a first controller 110c and a second controller 210c. FIG. 6 is a diagram of a case in which a multi-connection is formed between the first controller 110c and the second controller 210c, and serial data signals are transmitted. FIG. 6 may be described with reference to FIGS. 1 through 5, and duplicate descriptions thereof may be omitted.

Referring to FIG. 6, the first controller 110c may correspond to an example of the first controller 110 in FIG. 1. The first controller 110c may include a first synchronizer 114c, first through fifth pins P1_1c through P5_1c, and a clock generator 118c. The second controller 210c may correspond to an example of the second controller 210 in FIG. 1. The second controller 210c may include a second synchronizer 214c and first through fifth pins P1_2c through P5_2c. The first through fifth pins P1_1c through P5_1c of the first controller 110c may be electrically connected to the first through fifth pins P1_2c through P5_2c of the second controller 210c, respectively.

The synchronization signal provided by the first controller 110c to the second controller 210c may include the first trigger signal TRIG1 and the first data signal DP1. In addition, the first controller 110c may provide a clock signal CLK to the second controller 210c.

The first synchronizer 114c may provide the first trigger signal TRIG1 to the second controller 210c via the first pin P1_1c of the first controller 110c. The second controller 210c may receive the first trigger signal TRIG1 from the first synchronizer 114c via the first pin P1_2c of the second controller 210c. The first synchronizer 114c may provide the first data signal DP1 to the second controller 210c via the third pin P3_1c of the first controller 110c. In this case, the first data signal DP1 may include a serial data signal, and may include a signal representing k-bit data (where k is a natural number of 2 or more). The second controller 210c may receive the first data signal DP1 from the first synchronizer 114c via the third pin P3_2c of the second controller 210c. The clock generator 118c may generate the clock signal CLK, and provide the clock signal CLK to the second controller 210c via the fifth pin P5_1c of the first controller 110c.

The second controller 210c may receive the clock signal CLK via the fifth pin P5_2c of the second controller 210c, and read a value represented by the first data signal DP1 based on the clock signal CLK. When the first trigger signal TRIG1 and the first data signal DP1 are received from the first synchronizer 114c, the second controller 210c may perform the synchronization operation based on the value represented by the first data signal DP1.

In the embodiment, when the value represented by the first data signal DP1 is the first value (for example, 2'b00), the first data signal DP1 may include a signal that instructs the second controller 210c to change the operation mode thereof to the throttling mode.

In the embodiment, when the value represented by the first data signal DP1 is a second value (for example, 2'b01), the first data signal DP1 may include a signal that instructs the second controller 210c to stop the operation mode at the throttling mode and change the operation mode to the normal mode.

In the embodiment, when the value represented by the first data signal DP1 is a third value (for example, 2'b10), the first data signal DP1 may include a signal that instructs the second controller 210c to perform the garbage collection operation.

In the embodiment, when the value represented by the first data signal DP1 is a fourth value (for example, 2'b11), the first data signal DP1 may include a signal that instructs the second controller 210b to stop the garbage collection operation.

The synchronization signal provided by the second controller 210c to the first controller 110c may include the second trigger signal TRIG2 and the second data signal DP2.

The second synchronizer 214c may provide the second trigger signal TRIG2 to the first controller 110c via the second pin P2_2c of the second controller 210c. The first controller 110c may receive the second trigger signal TRIG2 from the second synchronizer 214c via the second pin P2_1c of the first controller 110c. The second synchronizer 214c may provide the second data signal DP2 to the first controller 110c via the fourth pin P4_2c of the second controller 210c. In this case, the second data signal DP2 may include a serial data signal, and may include a signal representing k-bit data (where k is a natural number of 2 or more). The first controller 110c may receive the second data signal DP2 from the second synchronizer 214c via the fourth pin P4_1c of the first controller 110c.

Based on the clock signal CLK generated by the clock generator 118c, the first controller 110c may read a value represented by the second data signal DP2.

When the second trigger signal TRIG2 and the second data signal DP2 are received from the second synchronizer 214c, the first controller 110c may perform the synchronization operation based on the value represented by the second data signal DP2. The synchronization operation according to the value represented by the second data signal DP2 may be the same as that of the first data signal DP1, and duplicate descriptions thereof may be omitted.

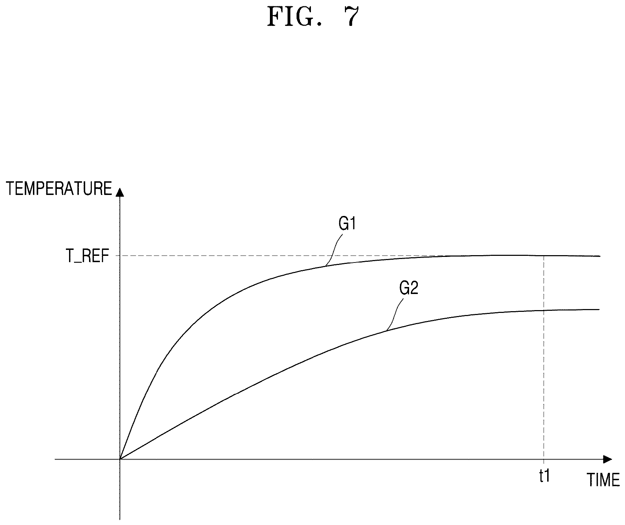

FIG. 7 is a diagram for describing that a storage device according to an embodiment generates a synchronization signal based on a temperature of the storage device. FIG. 7 may be described with reference to FIG. 1 through 6, and duplicate descriptions thereof may be omitted.

Referring to FIG. 7, a first graph G1 may be a graph of a temperature change of the first storage device 100 as the first storage device (100 in FIG. 1) performs an operation. A second graph G2 may be a graph of a temperature change of the second storage device 200 as the second storage device (200 in FIG. 1) performs an operation. Hereinafter, for convenience of description, the first storage device 100 is assumed, but it may be obvious that the same description can be applied to the second storage device 200.

In an embodiment, it is assumed that as the first storage device 100 performs a data transmission operation with the host (20 in FIG. 1), the temperature of the first storage device 100 gradually increases and reaches a reference value T_REF at a first time point t1. When the temperature of the first storage device 100 reaches the reference value T_REF, the first controller (110 in FIG. 1) may determine to change the operation mode of the first storage device 100 to the throttling mode. When the first controller 110 determines to change the operation mode of the first storage device 100 to the throttling mode, the first synchronizer (114 in FIG. 1) may, by providing a synchronization signal to the second storage device 200, operate not only the first storage device 100 but also the second storage device 200 in the throttling mode. In this manner, by synchronizing the operations of the first storage device 100 and the second storage device 200, the temperature of the entire memory package 10 including the first storage device 100 may be reduced in a short time.

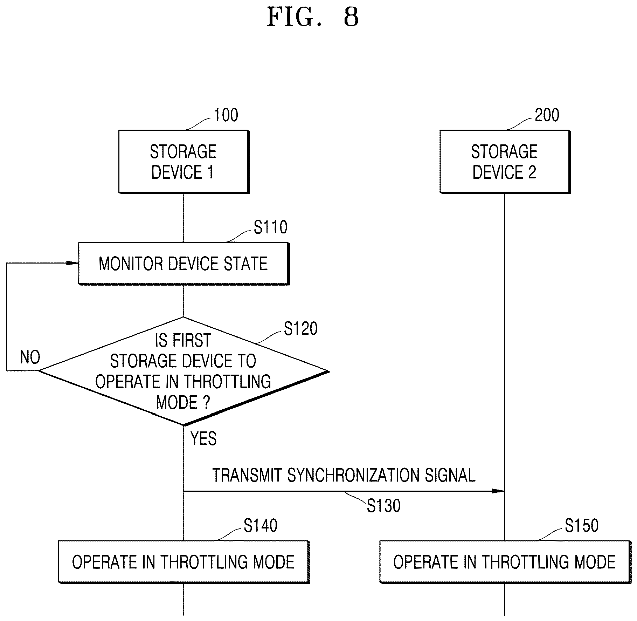

FIG. 8 is a flowchart of an operation of a storage device, according to an embodiment. FIG. 8 may be described with reference to FIG. 1 through 7, and duplicate descriptions thereof may be omitted.

Referring to FIG. 8, an embodiment is mainly described, in which the first storage device 100 triggers the operation of the second storage device 200 by providing the synchronization signal to the second storage device 200, but this is an example, and thus it is obvious that the second storage device 200 can trigger the operation of the first storage device 100.

In operation S110, the first storage device 100 may monitor the state of the first storage device 100 by using the first synchronizer 114.

In the embodiment, monitoring the state of the first storage device 100 by using the first synchronizer 114 may mean monitoring whether the temperature of the first storage device 100 exceeds a reference value.

In the embodiment, monitoring the state of the first storage device 100 by using the first synchronizer 114 may mean monitoring whether the first controller 110 has determined to change the operation mode of the first storage device 100 to the throttling mode as the temperature of the first storage device 100 exceeds the reference value.

In operation S120, when the temperature of the first storage device 100 reaches the reference value, the first storage device 100 may determine to change the operation mode to the throttling mode. In this case, the first synchronizer 114 may generate the synchronization signal. The synchronization signal may include a signal directing to change the operation mode of the second storage device 200 to the throttling mode.

In operation S130, the first storage device 100 may provide the synchronization signal generated by the first synchronizer 114 to the second storage device 200.

In the embodiment, the synchronization signal may include a trigger signal and a data signal.

In operation S140, the first storage device 100 may change the operation mode to the throttling mode, and continuously perform communication with the host 20. In the embodiment, operation S140 may be performed prior to operation S130.

In operation S150, the second storage device 200 may change the operation mode to the throttling mode, and continuously perform communication with the host 20.

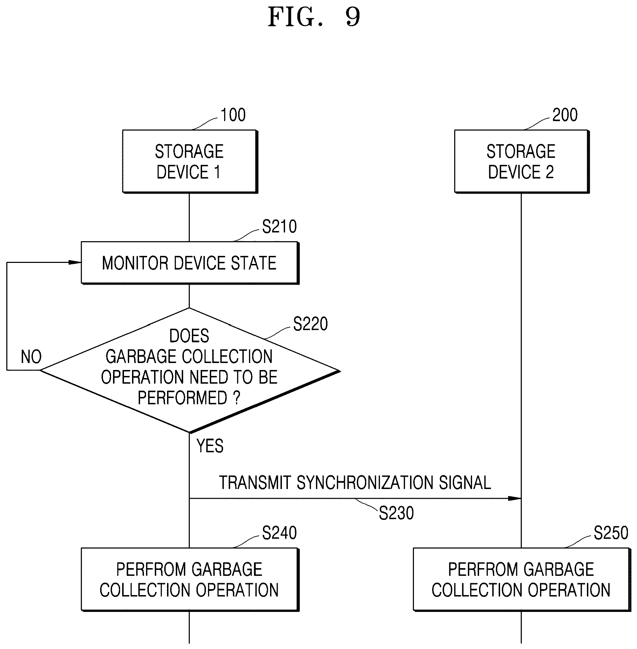

FIG. 9 is a flowchart of an operation of the storage device, according to an embodiment. FIG. 9 may be described with reference to FIGS. 1 through 7, and duplicate descriptions thereof may be omitted.

Referring to FIG. 9, an embodiment is mainly described, in which the first storage device 100 triggers the operation of the second storage device 200 by providing the synchronization signal to the second storage device 200, but this is an example, and thus it is obvious that the second storage device 200 can trigger the operation of the first storage device 100.

In operation S210, the first storage device 100 may monitor the state of the first storage device 100 by using the first synchronizer 114.

In the embodiment, monitoring the state of the first storage device 100 by using the first synchronizer 114 may mean monitoring whether the first storage device 100 performs the garbage collection operation. For example, the garbage collection operation may be performed every period, and the first synchronizer 114 may monitor whether such a period is reached.

In operation S220, when the first storage device 100 determines to perform the garbage collection operation, the first synchronizer 114 may generate the synchronization signal. The synchronization signal may include a signal directing the second storage device 200 also to perform the garbage collection operation.

In operation S230, the first storage device 100 may provide the synchronization signal generated by the first synchronizer 114 to the second storage device 200.

In the embodiment, the synchronization signal may include a trigger signal and a data signal.

In operation S240, the first storage device 100 may perform the garbage collection operation. In the embodiment, operation S240 may be performed prior to operation S230.

In operation S250, the second storage device 200 may perform the garbage collection operation.

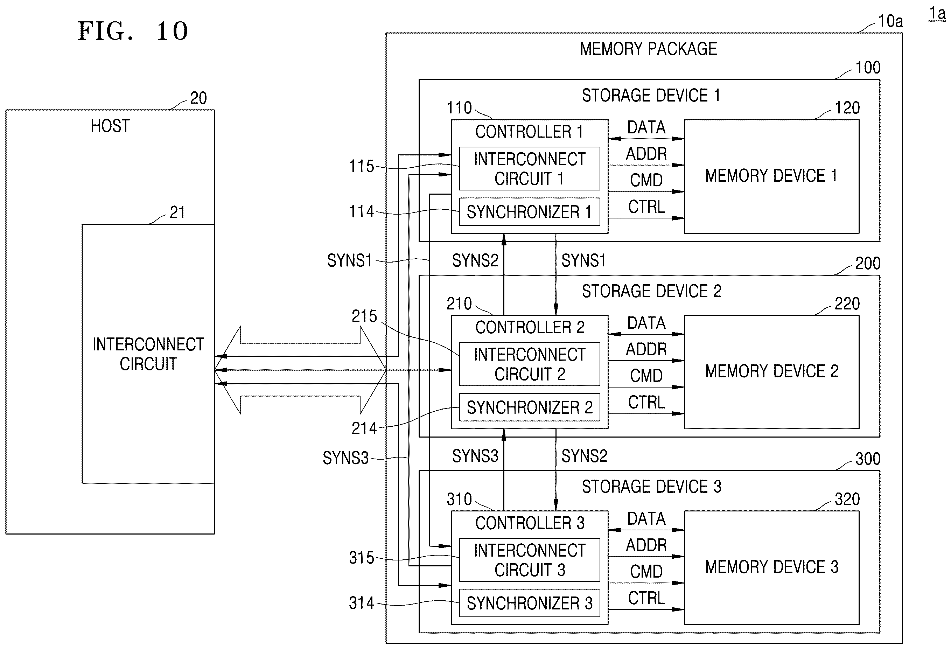

FIG. 10 is a block diagram of a system 1a according to an embodiment. FIG. 10 may be described with reference to FIGS. 1 through 9, and duplicate descriptions thereof may be omitted.

Referring to FIG. 10, the system 1a may include a memory package 10a and a host 20. The memory package 10a may include the first storage device 100, the second storage device 200, and a third storage device 300. Each storage device included in the memory package 10a may trigger other storage devices to perform the synchronization operation.

In the embodiment, the first storage device 100 may trigger at least one of the second storage device 200 and the third storage device 300 to perform the synchronization operation by using the first synchronization signal SYNS1.

In the embodiment, the second storage device 200 may trigger at least one of the first storage device 100 and the third storage device 300 to perform the synchronization operation by using the second synchronization signal SYNS2.

In the embodiment, the third storage device 300 may trigger at least one of the first storage device 100 and the second storage device 200 to perform the synchronization operation by using the third synchronization signal SYNS3.

The first storage device 100 may include the first controller 110 and the first memory device 120. The first controller 110 may include the first synchronizer 114 and the first interconnect circuit 115. The first storage device 100 may perform the same operation as the first storage device 100 in FIG. 1. However, unlike the memory package 10 of FIG. 1, because the memory package 10a in FIG. 10 includes three storage devices, the first storage device 100 may provide the first synchronization signal SYNS1 to both the second storage device 200 and the third storage device 300.

In the embodiment, the first synchronizer 114 may monitor the state of the first storage device 100, generate the first synchronization signal SYNS1 based on the monitoring result, and provide the first synchronization signal SYNS1 to the second controller 210 and a third controller 310. The second controller 210 and the third controller 310, which have received the first synchronization signal SYNS1, may perform the synchronization operation.

The second storage device 200 may include the second controller 210 and the second memory device 220. The second controller 210 may include the second synchronizer 214 and a second interconnect circuit 215. The second synchronizer 214 may monitor the state of the second storage device 200, generate a second synchronization signal SYNS2 based on the monitoring result, and provide the second synchronization signal SYNS2 to the first controller 110 and the third controller 310. The second storage device 200 may have components similar to those of the first storage device 100, and duplicate descriptions thereof are omitted.

The third storage device 300 may include the third controller 310 and a third memory device 320. The third controller 310 may include a third synchronizer 314 and a third interconnect circuit 315. The third synchronizer 314 may monitor the state of the third storage device 300, generate the third synchronization signal SYNS3 based on the monitoring result, and provide the third synchronization signal SYNS3 to the first controller 110 and the second controller 210. The third storage device 300 may have components similar to those of the first storage device 100, and duplicate descriptions thereof are omitted.

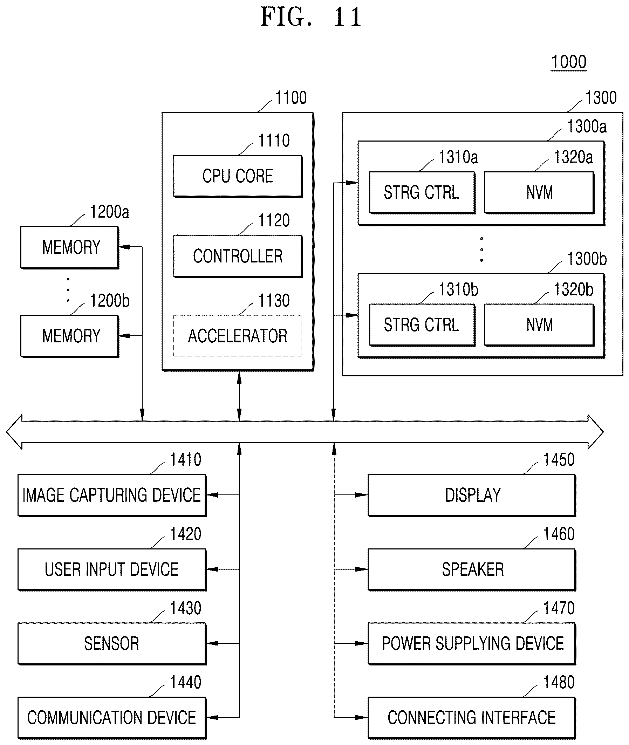

FIG. 11 is a system including a system 1000 according to an embodiment.

The system 1000 of FIG. 11 may basically include a mobile system, such as a mobile phone, a smartphone, a tablet personal computer (PC), a wearable device, a health care device, and an Internet of Things (IoT) device. However, the system 1000 of FIG. 11 is not necessarily limited to the mobile system, and may also include a PC, a laptop computer, a server, a media player, or an automotive device such as a navigation device.

Referring to FIG. 11, the system 1000 may include a main processor 1100, memories 1200a and 1200b, and a storage system 1300, and in addition, may include one or more of an image capturing device 1410, a user input device 1420, a sensor 1430, a communication device 1440, a display 1450, a speaker 1460, a power supplying device 1470, and a connecting interface 1480. In this case, each of the components constituting the system 1000 in FIG. 11, that is, the memories 1200a and 1200b, the storage system 1300, the image capturing device 1410, the user input device 1420, the sensor 1430, the communication device 1440, the display 1450, the speaker 1460, a power supplying device 1470, and the connecting interface 1480, may be implemented by using the embodiments described above with reference to FIGS. 1 through 10.

The main processor 1100 may control an entire operation of the system 1000, and more particularly, may control operations of other components constituting the system 1000. The main processor 1100 may be implemented as a general purpose processor, a dedicated processor, an application processor, etc.

The main processor 1100 may include one or more central processing unit (CPU) cores 1110, and may further include a controller 1120 for controlling the memories 1200a and 1200b and/or the storage system 1300. According to the embodiment, the main processor 1100 may further include an accelerator 1130, which is a dedicated circuit for high speed data computation such as an artificial intelligence (AI) data computation. The accelerator 1130 may include a graphics processing unit (GPU), a neural processing unit (NPU), and/or a data processing unit (DPU), or the like, and may be implemented as a separate chip, which is physically independent of other components of the main processor 1100.

The memories 1200a and 1200b may be used as a main memory device of the system 1000, and may include a volatile memory, such as SRAM and/or DRAM, but may also include an NVM, such as flash memory, PRAM, and/or resistive RAM (RRAM). The memories 1200a and 1200b may be implemented in the same package as the main processor 1100.

The storage system 1300 may include a storage device 1300a and a storage device 1300b. The storage device 1300a and the storage device 1300b may be configured to be included in one memory package. The storage devices 1300a and 1300b may function as non-volatile storage devices capable of storing data regardless of power supply, and may have relatively larger storage capacity than the memories 1200a and 1200b. The storage devices 1300a and 1300b may include storage controllers 1310a and 1310b, and non-volatile memories (NVMs) 1320a and 1320b storing data under the control of the storage controllers 1310a and 1310b. The NVMs 1320a and 1320b may include flash memory having a 2-dimensional (2D) or a 3-dimensional (3D) vertical (V)-NAND structure, but may also include NVMs of different types, such as PRAM and/or RRAM.

The storage system 1300 may be physically separated from the main processor 1100, or may be implemented in the same package as the main processor 1100. In addition, the storage system 1300 may have the same shape as an SSD or a memory card, and accordingly, may be detachably combined with other components of the system 1000 via an interface such as the connecting interface 1480 to be described below. The storage system 1300 may include devices to which a standard convention such as a UFS is applied, but is not necessarily limited thereto.

In the embodiment, the storage device 1300a may perform 2-lane communication with the main processor 1100, and the storage device 1300b may also perform 2-lane communication with the main processor 1100. In this case, the storage system 1300 may perform 4-lane communication with the main processor 1100.

The image capturing device 1410 may capture static images or video images, and may include a camera, a camcorder, and/or a webcam, etc.

The user input device 1420 may receive various types of data input by a user of the system 1000, and may include a touch pad, a keypad, a keyboard, a mouse, and/or a microphone, etc.

The sensor 1430 may sense various types of physical quantitites obtainable from the outside of the system 1000, and may convert the sensed physical quantitites into electrical signals. The sensor 1430 may include a temperature sensor, a pressure sensor, an illuminance sensor, a location sensor, an acceleration sensor, a biosensor, and/or a gyroscope, etc.

The communication device 1440 may communicate with other devices outside the system 1000 according to various communication conventions. The communication device 1440 may be implemented by including an antenna, a transceiver, and/or a modulator/demodulator (MODEM), etc.

The display 1450 and the speaker 1460 may function as output devices for outputting visual information and audio information to a user of the system 1000, respectively.

The power supplying device 1470 may properly convert power supplied by a battery (not illustrated) embedded in the system 1000 and/or an external power source, and provide the converted power to each component of the system 1000.

The connecting interface 1480 may provide a connection between the system 1000 and an external device connected to the system 1000 to exchange data with the system 1000. The connecting interface 1480 may be implemented in various interface methods, such as ATA, SATA, external SATA (e-SATA), SCSI, SAS, PCI, PCIe, node version manager (NVM) express (NVMe), IEEE 1394, USB, an SD card, an MMC, an eMMC, and a CF card.

Various changes in form and detail may be made without departing from the scope of the following claims.

## Claims

1. A memory package (10) comprising:
a first storage device (100) comprising a first controller (110; 110a) configured to communicate with a host (20); and
a second storage device (200) comprising a second controller (210; 210a) configured to communicate with the host (20), and perform a synchronization operation on the second storage device (200) based on a synchronization signal (SYNS1) received from the first controller (110; 110a),
wherein the first controller (110; 110a) comprises:
a first synchronizer (114; 114a) configured to generate the synchronization signal (SYNS1) based on a state of the first storage device (100), and
a first pin (P1_1a) electrically connected to the second controller (210; 210a), wherein the second controller (210; 210a) comprises:
a second synchronizer (214; 214a) configured to control the second controller (210; 210a) to perform the synchronization operation, based on the synchronization signal (SYNS1), and
a second pin (P1_2a) electrically connected to the first controller (110; 110a), and
wherein the first synchronizer (114; 114a) is configured to provide the synchronization signal (SYNS1) to the second synchronizer (214; 214a) via the first pin (P1_1a) and the second pin (P1_2a).

2. The memory package (10) of claim 1, wherein each of the first storage device (100) and the second storage device (200) is configured to perform communication with the host (20) according to a universal flash storage (UFS) interface.

3. The memory package (10) of claim 1 or 2, wherein the first controller (110) further comprises:
a first receiving circuit (115_1) configured to form a plurality of first downstream lanes (DL1_1, DL2_1) with the host (20), and
a first transmitting circuit (115_2) configured to form a plurality of first upstream lanes (UL1_1, UL2_1) with the host (20), and
wherein the second controller (210) further comprises:
a second receiving circuit (215_1) configured to form a plurality of second downstream lanes (DL1_2, DL2_2) with the host (20), and
a second transmitting circuit (215_2) configured to form a plurality of second upstream lanes (UL1_2, UL2_2) with the host (20).

4. The memory package (10) of claim 3, wherein a first number of lanes formed between the host (20) and the first controller (110) is the same as a second number of lanes formed between the host (20) and the second controller (210).

5. The memory package (10) of any preceding claim, wherein the state of the first storage device (100) comprises a temperature of the first storage device (100),
wherein the first synchronizer (114) is further configured to:
monitor the state of the first storage device (100),
generate the synchronization signal (SYNS1) based on identifying that the temperature of the first storage device (100) is greater than a reference value, and
provide the synchronization signal (SYNS1) to the second controller (210), and
wherein the second synchronizer (214) is further configured to control the second storage device (200) to operate in a throttling mode based on the synchronization signal (SYNS1).

6. The memory package (10) of any preceding claim, wherein the state of the first storage device (100) comprises whether the first storage device (100) performs a garbage collection operation,
wherein the first synchronizer (114) is further configured to:
monitor the state of the first storage device (100),
generate the synchronization signal (SYNS1) based on identifying that the first storage device (100) performs the garbage collection operation, and
provide the synchronization signal (SYNS1) to the second controller (210), and
wherein the second controller (210) is further configured to perform the garbage collection operation on the second storage device (200) based on the synchronization signal (SYNS1).

7. The memory package (10) of any preceding claim, wherein the first controller (110; 110a) further comprises a third pin (P3_1a) electrically connected to the second controller (210; 210a),
wherein the second controller (210; 210a) further comprises a fourth pin (P3_2a) electrically connected to the first controller (110; 110a),
wherein the synchronization signal (SYNS1) constitutes a first synchronization signal (SYNS1), and
wherein the first synchronizer (114; 114a) is further configured to:
provide a second synchronization signal (SYNS3) to the second synchronizer (214; 214a) via the third pin (P3_1a) and the fourth pin (P3_2a).

8. The memory package (10) of claim 7, wherein a second synchronization operation directed by the second synchronization signal (SYNS3) provided via the third pin (P3_1a) is different from the synchronization operation directed by the first synchronization signal (SYNS1) provided via the first pin (P1_1a).

9. A memory package (10) comprising:
a first storage device (100) comprising a first controller (110; 110c) configured to communicate with a host (20); and
a second storage device (200) comprising a second controller (210; 210c) configured to communicate with the host (20), and perform a synchronization operation on the second storage device (200) based on a trigger signal (TRIG1) received from the first controller (110; 110c),
wherein the first controller (110; 110c) comprises:
a first synchronizer (114; 114c) configured to generate the trigger signal (TRIG1) based on a state of the first storage device (100), and
a first trigger pin (P1_1c) and a first data pin (P3_1c) electrically connected to the second controller (210; 210c),
wherein the second controller (210; 210c) comprises:
a second synchronizer (214; 214c) configured to control the second controller (210; 210c) to perform the synchronization operation, based on the trigger signal (TRIG 1) and a data signal (DP1), and
a second trigger pin (P1_2c) and a second data pin (P3_2c) electrically connected to the first controller (110; 110c), and
wherein the first synchronizer (114; 114c) is further configured to:
provide the trigger signal (TRIG1) to the second synchronizer (214; 214c) via the first trigger pin (P1_1c) and the second trigger pin (P1_2c), and
provide the data signal (DP1) to the second synchronizer (214; 214c) via the first data pin (P3_1c) and the second data pin (P3_2c).

10. The memory package (10) of claim 9, wherein the second synchronizer (214; 214c) is further configured to perform the synchronization operation corresponding to the data signal (DP1), based on receiving the trigger signal (TRIG1) and the data signal (DP1).

11. The memory package (10) of claim 9 or 10, wherein the second synchronizer (214; 214c) is further configured to:
perform a first synchronization operation based on the data signal (DP1) being a first value;
stop the first synchronization operation based on the data signal (DP1) being a second value;
perform a second synchronization operation based on the data signal (DP1) being a third value; and
stop the second synchronization operation based on the data signal (DP1) being a fourth value.

12. The memory package (10) of any one of claims 9 to 11, wherein the first controller (110c) further comprises a first clock signal pin (P5_1c) electrically connected to the second controller (210c),
wherein the second controller (210c) further comprises a second clock signal pin (P5_2c) electrically connected to the first controller (110c),
wherein the first controller (110c) further comprises a clock generator (118c) configured to generate a clock signal (CLK), and provide the clock signal (CLK) to the second controller (210c) via the first clock signal pin (P5_1c) and the second clock signal pin (P5_2c), and
wherein the second controller (210c) is further configured to read a value represented by the data signal (DP1) based on the clock signal (CLK).

13. The memory package (10) of any one of claims 9 to 12, wherein each of the first storage device (100) and the second storage device (200) is configured to perform communication with the host (20) according to a universal flash storage (UFS) interface.

14. The memory package (10) of any one of claims 9 to 13, wherein the first controller (110; 110c) further comprises:
a first receiving circuit (115_1) configured to form a plurality of first downstream lanes (DL1_1, DL2_1) with the host (20), and
a first transmitting circuit (115_2) configured to form a plurality of first upstream lanes (UL1_1, UL2_1) with the host (20), and
wherein the second controller (210; 210c) further comprises:
a second receiving circuit (215_1) configured to form a plurality of second downstream lanes (DL1_2, DL2_2) with the host (20), and
a second transmitting circuit (215_2) configured to form a plurality of second upstream lanes (UL1_2, UL2_2) with the host (20).

15. The memory package (10) of any one of claims 9 to 14, wherein the state of the first storage device (100) comprises a temperature of the first storage device (100),
wherein the first synchronizer (114; 114c) is further configured to:
monitor the state of the first storage device (100),
generate the trigger signal (TRIG1) and the data signal (DP1) based on identifying that the temperature of the first storage device (100) is greater than a reference value, and
provide the trigger signal (TRIG1) and the data signal (DP1) to the second controller (210; 210c), and
wherein the second synchronizer (214; 214c) is further configured to control the second storage device (200) to operate in a throttling mode in response to the trigger signal (TRIG1) and the data signal (DP1).
